# EUROPEAN PATENT SPECIFICATION

(11) **EP 1 999 381 B1**
(45) Date of publication and mention of the grant of the patent: **22.11.2017**
(21) Application number: 07713245.4
(22) Date of filing: 14.03.2007
(51) Int. Cl.: F04D 33/00, H05K 7/20

(54) **COOLING DEVICE AND ELECTRONIC DEVICE COMPRISING SUCH A COOLING DEVICE**
KÜHLVORRICHTUNG UND ELEKTRONISCHES GERÄT MIT EINER SOLCHEN KÜHLVORRICHTUNG
APPAREIL DE REFROIDISSEMENT ET APPAREIL ÉLECTRONIQUE COMPRENANT UN TEL APPAREIL DE REFROIDISSEMENT

(30) Priority: 21.03.2006 EP 06111434
(43) Date of publication of application: 10.12.2008
(73) Proprietor: Philips Lighting Holding B.V., 5656 AE Eindhoven (NL)
(72) Inventor: AARTS, Ronaldus, M., NL-5656 AA Eindhoven (NL); LASANCE, Clemens, J., M., NL-5656 AA Eindhoven (NL)
(74) Representative: Verweij, Petronella Daniëlle
(86) International application number: PCT/IB2007/050859
(87) International publication number: WO 2007/107921

(56) References cited:
- EP-A- 1 529 963
- WO-A-2005/008348
- DE-A1- 19 539 020
- GB-A- 2 322 500
- JP-A- 3 211 796
- JP-A- 2004 274 383
- US-A- 4 942 939
- US-A- 5 894 990
- US-A1- 2007 081 027
- MEDNIKOV E P ET AL: "EXPERIMENTAL STUDY OF INTENSE ACOUSTIC STREAMING" SOVIET PHYSICS ACOUSTICS, AMERICAN INSTITUTE OF PHYSICS, NEW YORK, NY, US, vol. 21, no. 2, March 1975 (1975-03), pages 152-154, XP008083685 ISSN: 0038-562X
- GLEZER A ET AL: "Thermal Management Using Synthetic Jet Ejectors" IEEE TRANSACTIONS ON COMPONENTS AND PACKAGING TECHNOLOGIES, IEEE SERVICE CENTER, PISCATAWAY, NJ, US, vol. 27, no. 3, September 2004 (2004-09), pages 439-444, XP011118291 ISSN: 1521-3331
- LEE C ET AL: "A piezoelectrically actuated micro synthetic jet for active flow control" SENSORS AND ACTUATORS A, ELSEVIER SEQUOIA S.A., LAUSANNE, CH, vol. 108, no. 1-3, 15 November 2003 (2003-11-15), pages 168-174, XP004475542 ISSN: 0924-4247

## Description

The present invention relates to a cooling device comprising a transducer adapted to generate pressure waves at a drive frequency, and a tube, having a first end adapted to receive said pressure waves from the transducer, and a second end adapted to generate a pulsating net output flow towards the object.

The present invention further relates to an electronic device comprising such a cooling device.

Traditionally, cooling of electronic parts and systems is achieved by means of air cooling through natural or forced convection along an area provided at an outside of an electronic package, heat sink or fixture in general.

Recently, however, the need for cooling has increased in various applications due to higher heat flux densities resulting from newly developed electronic devices, being, for example, more compact and/or higher power than traditional devices. Examples of such improved devices include, for example, higher power semiconductor light-sources, such as lasers or light-emitting diodes, RF power devices and higher performance micro-processors, hard disk drives, optical drives like CDR, DVD and Blue ray drives, and large-area devices such as flat TVs and luminaires.

With respect to natural convection, the cooling capacity is on the one hand increasingly limited because of miniaturization and weight restrictions resulting in less available area, on the other hand by increasing the power-dissipating area (flat TV, light panels) resulting in excessive downstream local heating.

An obvious and ubiquitously implemented solution to this problem is to use fans. Although fans are continuously improved regarding compactness, noise and efficiency, various problems are still encountered due to more or less inherent properties of fans, such as size, noise, cost, expected life-time, minimum distance to objects and limited design freedom.

As an alternative to cooling by fans, document WO 2005/008348 discloses a synthetic jet actuator and a tube for cooling purposes. The tube is connected to a resonating cavity, and a jet stream is created at the distal end of the tube, and can be used to cool an object. The cavity and the tube form a Helmholtz resonator, i.e. a second order system where the air in the cavity acts as a spring, while the air in the tube acts as the mass.

A drawback with this type of system is that for a reasonable size cavity volume, the ratio between the tube section area and the tube length should be small, in order to obtain a low resonance frequency. However, to obtain a high acoustic output and a reasonable quality factor (Q), the section area of the tube should be large.

MEDNIKOV E P ET AL: "EXPERIMENTAL STUDY OF INTENSE ACOUSTIC STREAMING" SOVIET PHYSICS ACOUSTICS, AMERICAN INSTITUTE OF PHYSICS, NEW YORK, NY, US, vol. 21, no. 2, March 1975 (1975-03), pages 152-154, XP008083685 ISSN: 0038-562X discloses acoustical streaming using an eccentric vibrator.

In DE19539020, an electromagnetic convertor stimulates a standing acoustic wave in a first chamber of the pump housing. This chamber is filled with the gas or fluid to be pumped. At least one inlet and at least one outlet open out into the first chamber at a place where the chamber pressure periodically varies. The inlet and outlet are formed such that they present to the medium flowing into or out of the first chamber a resistance less than that presented to the medium flowing in the opposite direction. The electromagnetic convertor has an actuator whose dimensions and/or shape can be varied, e.g. a piezoelectric, electrostrictive, magnetostrictive, electromagnetic or electrodynamic actuator.

LEE C ET AL: "A piezoelectrically actuated micro synthetic jet for active flow control" SENSORS AND ACTUATORS A, ELSEVIER SEQUOIAS.A., LAUSANNE, CH, vol. 108, no. 1-3, 15 November 2003 (2003-11-15), pages 168-174, XP004475542 ISSN: 0924-4247 discloses a piezoelectric synthetic jet actuator. In WO 2005/008348 a system and a method for thermal management using distributed synthetic jet actuators is described. In view of the above-mentioned and other drawbacks of prior art, a general object of the present invention is to provide an improved cooling device.

A further object of the present invention is to provide a more versatile cooling device.

According to the present invention, these and other objects are achieved by a cooling device comprising a transducer adapted to generate pressure waves at a drive frequency, a tube, having a first end adapted to receive said pressure waves from the transducer, and a second end adapted to generate a pulsating net output flow towards said object, wherein the tube is a tube resonator having a length greater than λ/10, where λ is the wavelength of the pressure waves, and wherein the transducer is designed to have an impedance at the drive frequency 1.5 - 2.5 times greater, and preferably around two times greater, than a DC impedance of the transducer.

A "transducer" is here a device capable of converting an input signal to a corresponding pressure wave output. The input signal may be electric, magnetic or mechanical. Examples of suitable transducers include various types of membranes, pistons, piezoelectric structures and so on. In particular, a suitably dimensioned electrodynamic loudspeaker may be used as a transducer.

The present invention is based upon the realization that very efficient cooling may be achieved by using a tube resonator to achieve a gain in the velocity of the pulsating medium.

Compared to a Helmholtz resonator, where the length of the tube is short compared to the wavelength, the length of the tube resonator according to the present invention is greater than λ/10, which has been found to be sufficiently long to avoid Helmholtz resonance. Instead, the tube acts as a transmission line, that applies a velocity gain to the pulsating flow. An even better effect has been found for a tube length greater than λ/8, and an even better effect for a tube length greater than λ/5.

It can be shown that the velocity gain in the tube is inversely proportional to sin(2πL/λ) + cos(2πL/λ). This indicates that the gain will be maximal when sin(2πL/λ)≈1, i.e. when L≈(2n+1)λ/4.

In the specific case where the length of the tube is equal to (2n+1)λ/4, a standing wave is created in the tube resonator, causing an especially advantageous velocity gain.

The cooling device according to the present invention may be used for cooling a large variety of objects through directed outflow of various liquid or gaseous fluids. It is, however, particularly useful for air-cooling of such objects as electronic circuitry.

By dimensioning the tube resonator to generate a pulsating net fluid outflow through a center portion of an opening at a second end of the resonator, very efficient cooling is achieved in the direction of the outflow. This is especially the case since the pulsating flow of fluid emanating from an output of the cooling device according to the present invention destroys a boundary layer covering an object to be cooled very efficiently.

Ideally, the device is designed such that the cone excursion is minimal for a certain sound pressure level (SPL) at the second end of the tube. This results in a less expensive loudspeaker, e.g. simpler suspension of the transducer, and/or an improvement in life-time.

The specific relationship between drive frequency impedance and DC-impedance has been found to result in especially advantageous results. An important design parameter in this context is the force factor (*Bl*), which here is chosen such that the above mentioned drive frequency impedance is obtained.

The first end of the tube resonator can be arranged to receive the pressure waves directly from said transducer. This results in a compact design. A requirement of such a design is that the tube diameter essentially corresponds to the diameter of the transducer diaphragm.

Alternatively, and in order to handle any differences in diameter, a cavity volume can be arranged between the transducer and the tube. Such a cavity should not be confused with the cavity of a Helmholtz resonator. As explained above, the tube resonator is sufficiently long to avoid Helmholtz resonance.

Advantageously, the drive frequency may substantially coincide with the anti-resonance frequency of the system, i.e. the transducer in combination with the tube and any cavity there in between. The anti-resonance frequency is the frequency for which the impedance curve of the system reaches a local minimum. Such a selection of the drive frequency will result in an optimal output velocity.

The outflow may, furthermore, be essentially turbulent. Through suitable dimensioning of the open-ended structure and corresponding tuning of the transducer, turbulent outflow may be achieved at the output. Thereby, even more efficient cooling is obtained. In particular, the dimensioning and tuning is preferably such that a vortex formation formed at the second end travels a sufficient distance away from the opening at which it was formed during a forward stroke of the transducer to avoid being sucked back into the open-ended structure during a backward stroke.

The open-ended resonator may advantageously be dimensioned such that the outflow is pulsating at a frequency for which a minimum audible level is relatively high. The "minimum audible level" is the minimum sound pressure level audible to a human.

The minimum audible level is dependent on frequency with a minimum at about 4 kHz. In particular for low frequencies, the minimum audible level is relatively high. The open-ended resonator may therefore preferably be dimensioned to resonate at a frequency below 200 Hz, and more preferably at a frequency below 100 Hz.

Furthermore, the transducer may advantageously be set to generate pressure waves at such a level that a pressure level of the outflow is below the minimum audible level. Hereby, the cooling device may be configured to operate inaudibly.

According to an alternative embodiment, the tube resonator may have a plurality of openings at its second end. These openings may be directed in essentially the same direction or in different directions in order to simultaneously cool several objects. Furthermore, the openings may be in substantially the same plane or in different planes.

The tube may, for example, be cylindrical and have a length, a radius and two ends. Acoustic resonance frequencies of a tube are easily calculated and the manufacturing of a cylindrical tube in particular is straight-forward.

According to one embodiment, this tube may be substantially straight, whereby a particularly large frequency selective amplification, or in other words, high acoustic quality factor (Q), is obtained.

The tube may further have an elongated opening at least partly extending along a length of the tube, in order to at least partly emit the cooling outflow through this elongated opening.

Of course, several openings of various shapes may be formed in the tube.

Through the formation of such an elongated opening, the cooling fluid flow can be adapted to the object to be cooled.

According to another embodiment, the tube may be substantially coil shaped. By forming the tube as a coil or other arrangement, such as a labyrinth, more compact than a straight tube, a space-saving cooling device can be realized.

Further, apart from the jet formed at the end of the tube due to the train of vortices, a secondary flow of entrained ambient air may be introduced in order to increase the cooling effect. This secondary flow may be drawn from a location at some distance from the opening. Especially when the object to be cooled is in a confined compartment, it may be advantageous to draw air from a different location. According to one embodiment, a second tube can be arranged coaxially with the tube resonator and have an opening at a suitable location to let cold ambient air be drawn in.

The cooling device according to the present invention may, furthermore, advantageously be comprised in an electronic device including electronic circuitry.

These and other aspects of the present invention will now be described in more detail, with reference to the appended drawings showing currently preferred embodiments of the invention.
Fig 1a is a schematic plane view of a cooling device according to a first embodiment of the present invention.
Fig 1b is a schematic plane view of a cooling device according to a second embodiment of the present invention.
Fig 2 is a perspective view of the tube resonator in fig 1a and 1b.
Fig 3 is a diagram illustrating a preferred operating range of a cooling device according to the present invention.
Fig 4 is a schematic perspective view of a cooling device according to a second embodiment of the present invention.
Fig 5 is a schematic perspective view of a cooling device according to a third embodiment of the present invention.
Fig 6 is a schematic perspective view of a cooling device according to a fourth embodiment of the present invention.
Fig 7 is a schematic plane view of a variant of the cooling device in fig 1b.

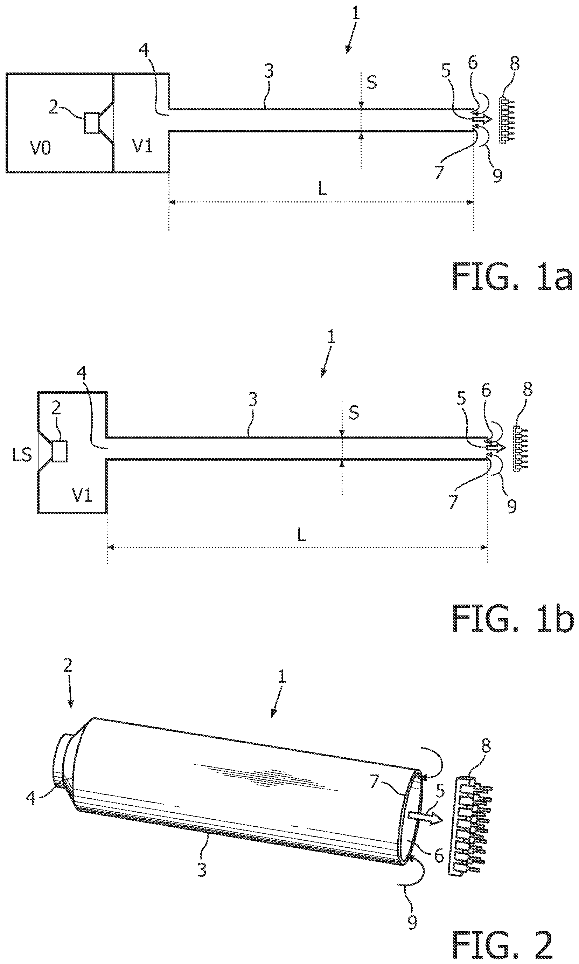

Figures 1a and 1b schematically show a cooling device according to two embodiments of the invention.

The exemplary cooling device 1 is formed by a transducer 2, in the form of a loudspeaker membrane and a tube resonator 3. A first end 4 of the tube 3 is arranged to receive pressure waves from the transducer 2. By selecting proper dimensions, in this case cross section S and length L of the tube 3, a pulsating net fluid outflow 5 through the opening 6 of the second end 7 of the tube 3 is obtained. Through this fluid outflow 5, an object 8, e.g. an electrical circuit or integrated circuit, in the direction of the outflow 5 is cooled.

The tube has a length L greater than λ/10, causing a gain in velocity and preventing the tube from acting as the neck of a Helmholtz resonator. Most preferably, the length L is essentially equal to an odd multiple of λ/4, i.e. (2n+1)λ/4, where n=0, 1, 2, ... Such a tube length will result in a standing wave in the tube, which provides a particularly efficient velocity gain.

The tube preferably has a high quality factor Q leading to a high gain, i.e. ratio between input velocity and output velocity. One of the measures to obtain this is to have smooth tube walls.

According to a preferred embodiment, there is no total net flow through the tube 3. Instead, an amount of fluid corresponding to that ejected in the center portion outflow 5 is pulled into the tube 3 at the perimeter of the opening 6, as indicated by the curved arrows 9 in fig 1a, due to the drag of the jet.

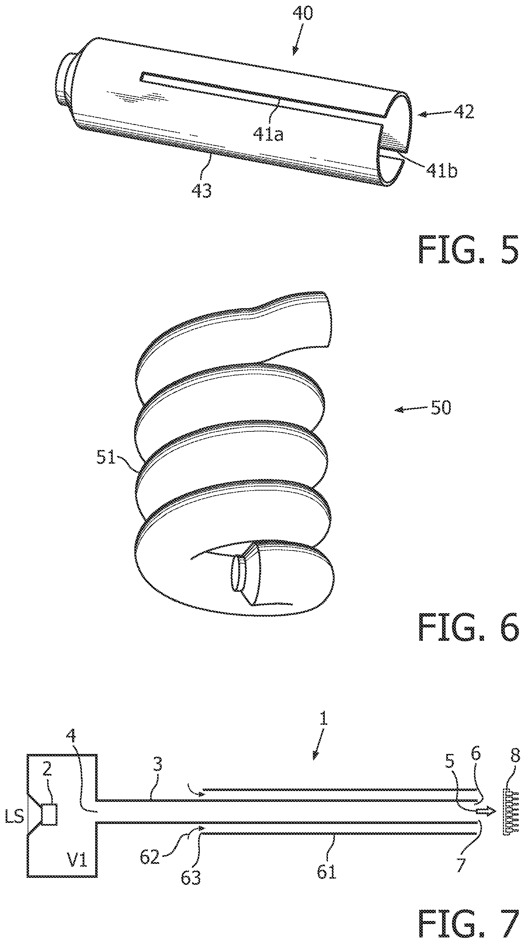

However, for example in a situation where the object 8 is situated in a confided space, where the air is heated, it may be advantageous to draw air from some other location. For this purpose, the device can be provided with an additional channel leading from such a location to the opening 6 of the tube 3. Figure 7 shows an example of such a design. In this example, a second tube 61 is arranged coaxially with the tube 3, with one end close to the opening 6, and its other end 63 at a distance from the opening 6. In operation, a secondary fluid flow 62 is drawn into this tube, enabling introduction of colder air into a hot spot.

In the embodiment shown in figure 1a, a cavity volume V0 is provided behind the transducer 2, and a cavity volume V1 is provided between the transducer 2 and the tube resonator 3. In the embodiment in figure 1b, there is only a cavity volume V1. The cavity volume V1 is not required to perform the invention, but may be advantageous to compensate different diameters of the transducer 2 and the tube 3. The direction of the transducer is not of importance and might be reversed.

Fig 2 is a schematic perspective view of a cooling device 1 according to a further embodiment of the present invention. Identical reference numerals have been used for elements corresponding to elements in figures 1a and 1b, but should not be regarded as restricting these previous figures.

In fig 2, the tube resonator 3 has a cylindrical or circular cross-section and the transducer 2 is provided in the form of a loudspeaker membrane and attached to the first end 4 of the tube. It should be noted that this by no means limits the scope of the invention, which is equally applicable to cooling devices including other types of open-ended resonators, such as tubes with differently shaped, for example rectangular, cross-sections, and open-ended resonators having varying cross-section along their extensions. Furthermore, the transducer may be provided in the form of any other means capable of generating pressure waves. Such means include, for example, piezo-electric transducers, mechanically movable pistons, etc. Additionally, the transducer need not necessarily be tightly attached to the open-ended resonator as illustrated in the appended drawings, but may alternatively be physically separated from the open-ended resonator, as long as the open-ended resonator is arranged, in relation to the transducer, so that the pressure waves generated by the transducer are coupled into the first end of the open-ended resonator.

In many applications, an important feature of a cooling device is that it remains unnoticed to a user. The cooling device is therefore preferably designed to be compact and silent.

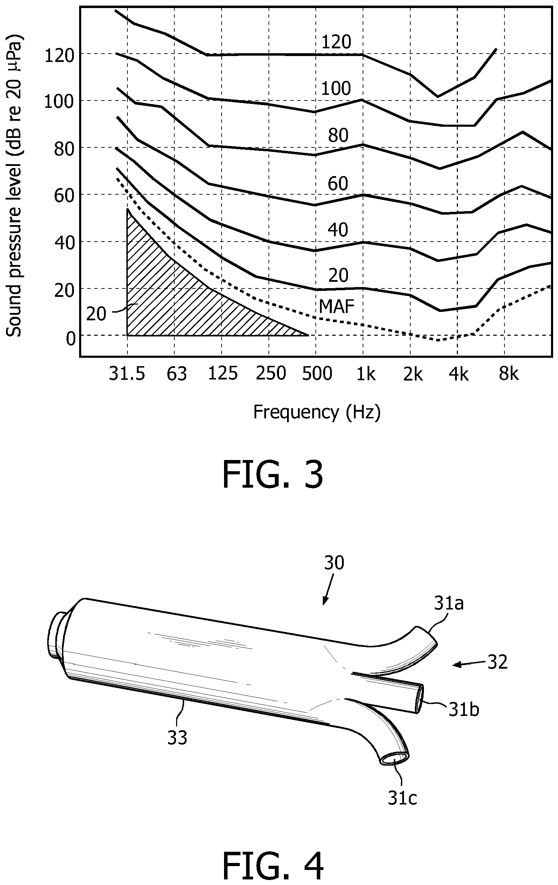

With reference to fig 3, showing an equal loudness chart, a preferred operating region of the cooling device according to the present invention is schematically illustrated as the hatched area 20 in fig 3. The preferred operating region 20 is located below the minimum audible level and a cooling device which is designed/dimensioned to operate within this region 20 is not audible to a user. It should be noted that the cooling device according to the present invention may well exceed the limits of this preferred region while still being more or less unnoticeable to the user. The finally chosen operating point in the chart in fig 3 depends on factors such as size limitations, required cooling power, sound emission level by other parts of the system into which the cooling device is implemented.

In fig 4, a cooling device 30 according to yet another embodiment of the present invention is schematically shown, which differs from the cooling device 1 in fig 2 in that the cooling outflow here is generated at the three openings 31a-c at the second end 32 of the tube 33.

Hereby, several objects may be cooled using the same cooling device 30.

In fig 5, a cooling device 40 according to a further embodiment of the present invention is schematically shown, which differs from the cooling device 1 in fig 2 in that the cooling outflow here takes place through elongated openings 41a-b as well as through the opening at the second end 42 of the tube 43.

This embodiment is particularly useful for cooling of extended objects.

In fig 6, a cooling device 50 according to yet another embodiment of the present invention is schematically shown, which differs from the cooling device 1 in fig 2 in that the tube 51 is here wound to a coil-shape. This arrangement allows for dimensioning the tube 51 within the desired operating region 20 while keeping the total dimensions of the cooling device 50 as compact as possible.

The person skilled in the art realizes that the present invention by no means is limited to the preferred embodiments. For example, the transducer can be connected to the tube in various ways, and the tube does not need to have a circular cross section.

## Claims

1. A cooling device using pulsating fluid for cooling of an object (8), comprising:
a transducer (2) adapted to generate pressure waves at a drive frequency,
a tube (3), having a first end (4) adapted to receive said pressure waves from the transducer, and a second end (7) adapted to generate a pulsating net output flow towards said object,
**characterized in that** said tube is a tube resonator (3) having a length (L) greater than λ/10, where λ is the wavelength of the pressure waves,
wherein said transducer has an impedance at said drive frequency 1.5 - 2.5 times greater than a DC-impedance of said transducer.

2. The device according to claim 1, wherein the tube resonator has a length (L) greater than λ/8, and preferably greater than λ/5.

3. The device according to claim 1, wherein the tube resonator has a length (L) essentially equal to (2n+1)λ/4, where n=0,1,2,... and λ is the wavelength of said pressure waves.

4. The device according to claim 3, wherein said transducer is designed to have an impedance at said drive frequency approximately 2 times greater than the DC-impedance.

5. A cooling device according to any one of the preceding claims, wherein the first end (4) of the tube resonator (3) is arranged to receive said pressure waves directly from said transducer (2).

6. A cooling device according to any one of claims 1 - 4, wherein a cavity volume (V1) is arranged between the transducer and the tube resonator.

7. A cooling device according to any one of the preceding claims, wherein said drive frequency substantially coincides with an anti-resonance frequency of a system comprising the transducer (2), the tube resonator (3) and any cavity (V1) there in between.

8. A cooling device according to any one of the preceding claims, wherein said tube resonator (3) is adapted to reduce a total net flow through said opening.

9. A cooling device according to any one of the preceding claims, wherein said drive frequency is selected such that said net output flow is essentially turbulent.

10. A cooling device according to any one of the preceding claims, wherein the second end (7) has a plurality of openings.

11. A cooling device according to one of preceding claims, wherein said tube is substantially straight.

12. A cooling device according to any one of claims 1-10, wherein said tube is substantially coil shaped.

13. A cooling device according to any one of the preceding claims, wherein said tube has an elongated opening at least partly extending along a length of said tube, in order to at least partly emit said output flow through said elongated opening.

14. A cooling device according to any one of the preceding claims, comprising a channel (61) for introducing a secondary flow (62) of fluid from a location at some distance from the second end (7) of the resonator.

15. An electronic device comprising electronic circuitry and a cooling device according to any one of the preceding claims for cooling said circuitry.

## Patentansprüche

1. Kühlvorrichtung, die pulsierendes Fluid zum Kühlen eines Objekts (8) verwendet und Folgendes umfasst:
einen Wandler (2), der angepasst ist, Druckwellen mit einer Ansteuerfrequenz zu erzeugen,
ein Rohr (3), das ein erstes Ende (4) aufweist, das angepasst ist, die Druckwellen vom Wandler zu empfangen, und ein zweites Ende (7), das angepasst ist, einen pulsierenden Nettoausgangsfluss zum Objekt zu erzeugen,
**dadurch gekennzeichnet, dass** das Rohr ein Rohrresonator (3) ist, der eine Länge (L) aufweist, die größer als λ/10 ist, wo λ die Wellenlänge der Druckwellen ist,
wobei der Wandler eine Impedanz bei der Ansteuerfrequenz aufweist, die 1,5-2,5 Mal größer ist als eine DC-Impedanz des Wandlers.

2. Vorrichtung nach Anspruch 1, wobei der Rohrresonator eine Länge (L) aufweist, die größer ist als λ/8 und vorzugsweise größer als λ/5.

3. Vorrichtung nach Anspruch 1, wobei der Rohrresonator eine Länge (L) aufweist, die grundsätzlich gleich (2n+1)λ/4 ist, wo n=0,1,2,... und λ die Wellenlänge der Druckwellen ist.

4. Vorrichtung nach Anspruch 3, wobei der Wandler dazu ausgebildet ist, bei der Ansteuerfrequenz eine Impedanz aufzuweisen, die ungefähr 2 Mal größer ist als die DC-Impedanz.

5. Kühlvorrichtung nach einem der vorhergehenden Ansprüche, wobei das erste Ende (4) des Rohrresonators (3) angeordnet ist, die Druckwellen direkt vom Wandler (2) zu empfangen.

6. Kühlvorrichtung nach einem der Ansprüche 1-4, wobei das Hohlraumvolumen (V1) zwischen dem Wandler und dem Rohrresonator angeordnet ist.

7. Kühlvorrichtung nach einem der vorhergehenden Ansprüche, wobei die Ansteuerfrequenz im Wesentlichen mit einer Antiresonanzfrequenz eines Systems zusammenfällt, das den Wandler (2), den Rohrresonator (3) und jeden Hohlraum (V1) dazwischen umfasst.

8. Kühlvorrichtung nach einem der vorhergehenden Ansprüche, wobei der Rohrresonator (3) angepasst ist, einen Nettogesamtfluss durch die Öffnung zu reduzieren.

9. Kühlvorrichtung nach einem der vorhergehenden Ansprüche, wobei die Ansteuerfrequenz derart ausgewählt ist, dass der Nettoausgangsfluss grundsätzlich turbulent ist.

10. Kühlvorrichtung nach einem der vorhergehenden Ansprüche, wobei das zweite Ende (7) eine Vielzahl von Öffnungen aufweist.

11. Kühlvorrichtung nach einem der vorhergehenden Ansprüche, wobei das Rohr im Wesentlichen gerade ist.

12. Kühlvorrichtung nach einem der Ansprüche 1-10, wobei das Rohr im Wesentlichen schlangenförmig ist.

13. Kühlvorrichtung nach einem der vorhergehenden Ansprüche, wobei das Rohr eine längliche Öffnung aufweist, die sich mindestens teilweise entlang der Länge des Rohrs erstreckt, um den Ausgangsfluss mindestens teilweise durch die längliche Öffnung auszugeben.

14. Kühlvorrichtung nach einem der vorhergehenden Ansprüche, die einen Kanal (61) zum Einleiten eines sekundären Flusses (62) von Fluid von einem Ort in einem gewissen Abstand vom zweiten Ende (7) des Resonators umfasst.

15. Elektronische Vorrichtung, die eine elektronische Schaltung und eine Kühlvorrichtung nach einem der vorhergehenden Ansprüche zum Kühlen der Schaltung umfasst.

## Revendications

1. Dispositif de refroidissement utilisant un fluide à pulsations pour le refroidissement d'un objet (8), comprenant :
un transducteur (2) adapté pour générer des ondes de pression à une fréquence d'excitation,
un tube (3), possédant une première extrémité (4) adaptée pour recevoir lesdites ondes de pression à partir du transducteur, et une seconde extrémité (7) adaptée pour générer un écoulement de sortie net à pulsations vers ledit objet,
**caractérisé en ce que** ledit tube est un résonateur tubulaire (3) possédant une longueur (L) supérieure à λ/10, où λ est la longueur d'onde des ondes de pression,
dans lequel ledit transducteur présente une impédance à ladite fréquence d'excitation 1,5 à 2,5 fois supérieure à une impédance CC dudit transducteur.

2. Dispositif selon la revendication 1, dans lequel le résonateur tubulaire présente une longueur (L) supérieur à λ/8, et de préférence supérieure à λ/5.

3. Dispositif selon la revendication 1, dans lequel le résonateur tubulaire présente une longueur (L) essentiellement égale à (2n+1)λ/4, où n = 0, 1, 2,... et λ est la longueur d'onde desdites ondes de pression.

4. Dispositif selon la revendication 3, dans lequel ledit transducteur est conçu pour présente une impédance à ladite fréquence d'excitation approximativement 2 fois supérieure à l'impédance CC.

5. Dispositif de refroidissement selon l'une quelconque des revendications précédentes, dans lequel la première extrémité (4) du résonateur tubulaire (3) est agencée pour recevoir lesdites ondes de pression directement à partir dudit transducteur (2).

6. Dispositif de refroidissement selon l'une quelconque des revendications 1 à 4, dans lequel un volume de cavité (V1) est agencé entre le transducteur et le résonateur tubulaire.

7. Dispositif de refroidissement selon l'une quelconque des revendications précédentes, dans lequel ladite fréquence d'excitation coïncide sensiblement avec une fréquence antirésonance d'un système comprenant le transducteur (2), le résonateur tubulaire (3) et une quelconque cavité (V1) entre ceux-ci.

8. Dispositif de refroidissement selon l'une quelconque des revendications précédentes, dans lequel ledit résonateur tubulaire (3) est adapté pour réduire un écoulement net total à travers ladite ouverture.

9. Dispositif de refroidissement selon l'une quelconque des revendications précédentes, dans lequel ladite fréquence d'excitation est sélectionnée de telle sorte que ledit écoulement de sortie net soit essentiellement turbulent.

10. Dispositif de refroidissement selon l'une quelconque des revendications précédentes, dans lequel la seconde extrémité (7) possède une pluralité d'ouvertures.

11. Dispositif de refroidissement selon l'une des revendications précédentes, dans lequel ledit tube est sensiblement droit.

12. Dispositif de refroidissement selon l'une quelconque des revendications 1 à 10, dans lequel ledit tube présente sensiblement une forme hélicoïdale.

13. Dispositif de refroidissement selon l'une quelconque des revendications précédentes, dans lequel ledit tube possède une ouverture allongée s'étendant au moins partiellement le long d'une longueur dudit tube, afin d'émettre au moins partiellement ledit écoulement de sortie à travers ladite ouverture allongée.

14. Dispositif de refroidissement selon l'une quelconque des revendications précédentes, comprenant un canal (61) pour introduire un écoulement secondaire (62) de fluide à partir d'un emplacement à une certaine distance de la seconde extrémité (7) du résonateur.

15. Dispositif électronique comprenant une circuiterie électronique et un dispositif de refroidissement selon l'une quelconque des revendications précédentes pour refroidir ladite circuiterie.
